Europäisches Patentamt

European Patent Office

Office européen des brevets

(19)

(11) Numéro de publication : **0 176 644**
**B1**

(12) **FASCICULE DE BREVET EUROPÉEN**

(45) Date de publication du fascicule du brevet :
**11.01.89**

(21) Numéro de dépôt : **84402359.8**

(22) Date de dépôt : **20.11.84**

(51) Int. Cl.⁴ : **G 12 B   9/00**, G 01 D 11/24,
**B 29 C 31/04**

(54) **Boîtier anti-choc, notamment pour appareil portatif de mesure.**

(30) Priorité : **30.11.83 FR 8319094**

(43) Date de publication de la demande :
**09.04.86 Bulletin 86/15**

(45) Mention de la délivrance du brevet :
**11.01.89 Bulletin 89/02**

(84) Etats contractants désignés :
**AT DE GB IT NL**

(56) Documents cités :
**FR--A-- 1 104 477
FR--A-- 2 188 908
FR--A-- 2 403 625
GB--A--   493 009**

(73) Titulaire : **CONSTRUCTION D'APPAREILLAGE**
**Société anonyme**
**5 rue du Square Carpeaux**
**F-75018 Paris (FR)**

(72) Inventeur : **Arnoux, Daniel**
**10 bis rue d'Alsace**
**F-78100 Saint Germain en Laye (FR)**
Inventeur : **Haye, Maurice**
**9 rue de la Fontaine**
**F-91560 Crosnes (FR)**
Inventeur : **Bonneau, Daniel**
**1 rue Ecaillé**
**F-95740 Frépillon (FR)**

(74) Mandataire : **Lefebure, Gérard et al**
**Office Blétry 2, boulevard de Strasbourg**
**F-75010 Paris (FR)**

## Description

La présente invention concerne un boîtier antichoc, notamment pour appareil portatif de mesure, du type comprenant deux parties assemblables l'une à l'autre, en une matière élastomère moulable, l'une des deux parties comportant une paroi principale ayant une ouverture dans la périphérie de laquelle est formée une feuillure élastique d'encadrement, et une plaque en une matière nettement plus rigide que ladite matière élastomère, qui est encastrée dans ladite feuillure.

On connaît déjà un boîtier antichoc de ce type par le brevet français n° 2 188 908 de la demanderesse. Plusieurs difficultés ont été rencontrées dans la réalisation de ce boîtier connu. Une première difficulté réside dans l'obtention d'une liaison suffisante entre les parties du boîtier en une matière élastomère, d'une part, et les parties rigides ou semi-rigides qu'il contient, d'autre part. C'est le cas notamment pour la glace de protection du cadran de l'appareil de mesure. En effet, avec le boîtier antérieurement connu, on a constaté que, en cas de choc particulièrement sévère, par exemple en cas de chute sur le sol, la glace de protection a tendance à se déboîter de la feuillure susmentionnée, voire même à sortir complètement de la feuillure. Une seconde difficulté réside dans le positionnement et la liaison au boîtier de la platine intérieure portant les composants de l'appareil de mesure (composants électriques, composants électroniques, indicateur de mesure — galvanomètre ou afficheur numérique). Une troisième difficulté réside dans l'obtention d'um boîtier dont les parois présentent une élasticité variable en épaisseur. A cet effet, le brevet français n° 2 188 908 prévoit des éléments élastiques en relief sur les faces du boîtier, ces éléments élastiques en relief étant évidés extérieurement ou intérieurement, les cavités ainsi obtenues étant éventuellement obturées afin d'obtenir une multitude de volumes étanches, remplis d'air et parfaitement élastiques. Une autre solution proposée par le brevet français n° 2 188 908 consiste à utiliser une matière plastique ou élastomère qui a elle-même une élasticité variable dans son épaisseur, de manière à avoir une dureté relativement élevée et une élasticité plus faible du côté intérieur et, au contraire, une dureté relativement faible et une élasticité plus élevée du côté extérieur. Ces deux solutions se sont révélées difficiles à réaliser en pratique.

La présente invention a principalement pour but d'améliorer la liaison entre la plaque rigide ou semi-rigide susmentionnée et la partie en matière élastomère du boîtier.

La présente invention a également pour but de fournir un certain nombre d'aménagements constructifs facilitant la réalisation d'un boîtier antichoc, tout en améliorant simultanément ses qualités de robustesse.

A cet effet, le boîtier antichoc selon la présente invention est caractérisé en ce que ladite plaque comporte plusieurs cavités dans sa région périphérique encastrée dans la feuillure, et en ce que ladite partie du boîtier qui comporte l'ouverture est réalisée par surmoulage sur ladite plaque, de telle façon que la matière élastomère remplisse lesdites cavités de la plaque lors du moulage.

De cette manière, on obtient une liaison efficace entre la plaque et la partie en matière élastomère du boîtier.

D'autres caractéristiques et avantages de la présente invention ressortiront au cours de la description qui va suivre d'une forme d'exécution du boîtier antichoc.

Les figures 1 et 2 sont des vues, respectivement de dessus et de dessous, du boîtier antichoc pour un appareil de mesure.

La figure 3 est une vue en coupe suivant la ligne III-III de la figure 1 montrant, à plus grande échelle, les deux parties du boîtier détachées l'une de l'autre.

La figure 4 est une vue de dessus de la glace de protection du cadran du boîtier de la figure 1.

La figure 5 est une vue partielle en coupe suivant la ligne V-V de la figure 4, montrant, à plus grande échelle, un détail de la liaison entre la glace de protection et la partie en matière élastomère du boîtier.

La figure 6 est une vue similaire à la figure 5, montrant une variante.

Les figures 7 à 9 sont des vues partielles en coupe, montrant d'autres dispositions possibles pour les éléments élastiques en relief du boîtier.

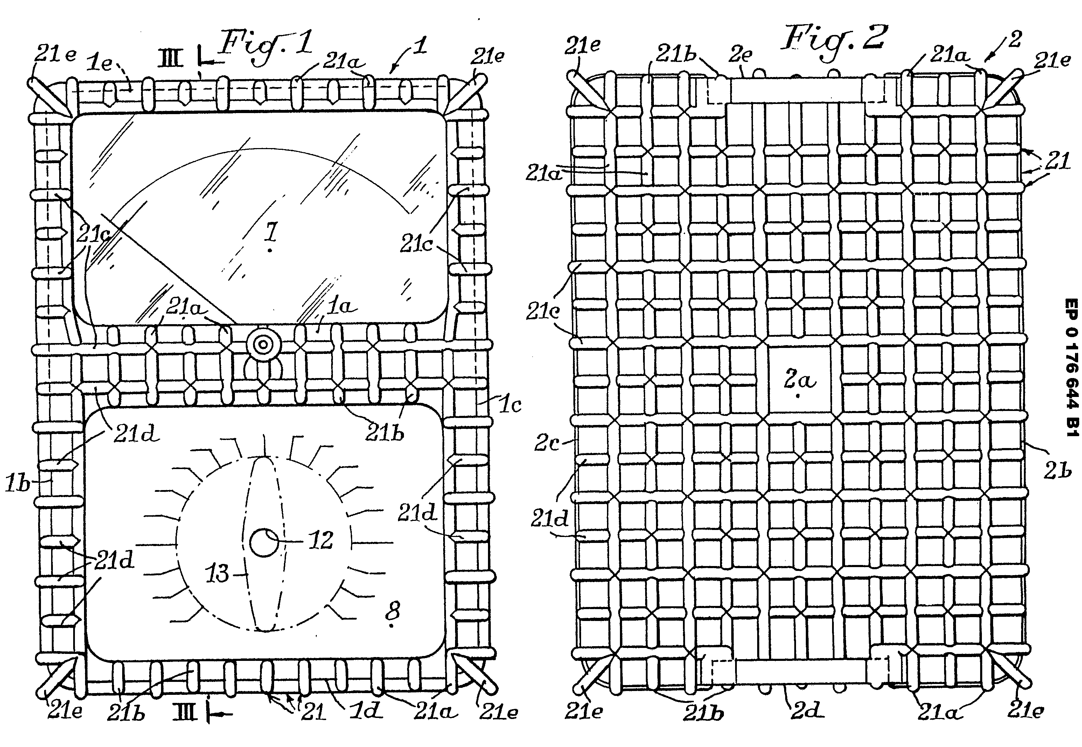

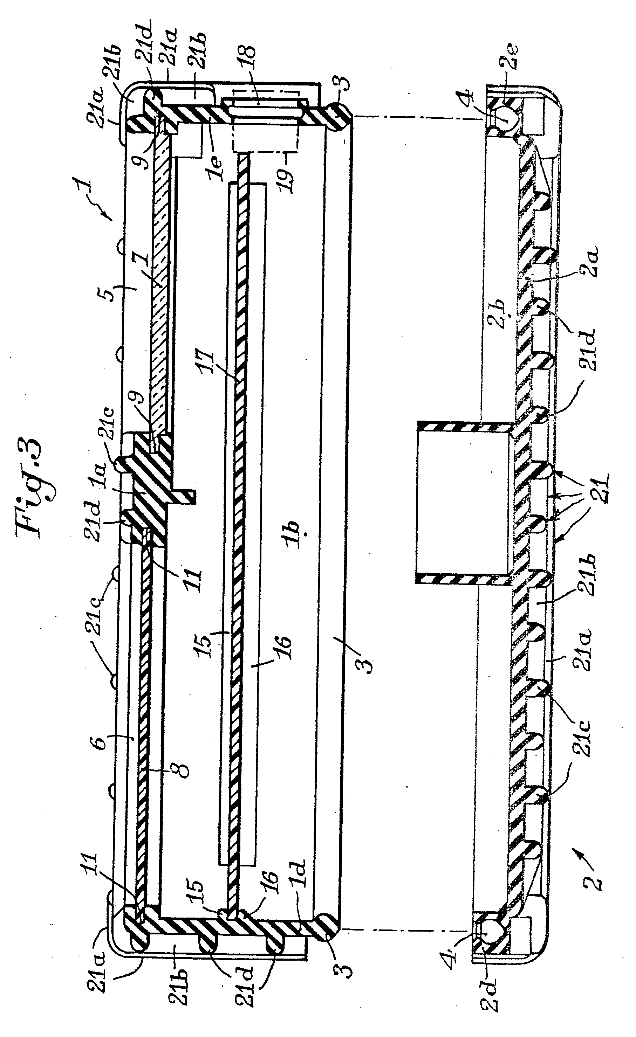

Le boîtier représenté sur les figures 1 à 3 comprend une partie supérieure 1 et une partie inférieure 2 en une matière élastomère moulable. Les parties 1 et 2 peuvent être assemblées l'une à l'autre, de manière détachable, par encliquetage élastique, au moyen d'une nervure 3 et d'une rainure 4 dont les sections transversales ont des formes complémentaires l'une de l'autre. Comme montré dans la figure 3, la nervure 3 et la rainure 4 ont, vue en coupe transversale, la forme d'un bulbe. Bien que dans la figure 3, la nervure 3 soit représentée solidaire de la partie supérieure 1 et la rainure 4 formée dans la partie inférieure 2, on pourrait bien entendu avoir la disposition inverse.

Dans sa paroi supérieure 1a, la partie supérieure 1 comporte deux larges ouvertures rectangulaires 5 et 6. Deux plaques 7 et 8 sont encastrées respectivement dans des feuillures 9 et 11, en forme de profondes rainures, prévues dans la périphérie de chacune des ouvertures 5 et 6. La plaque 7 est une glace de protection en verre de sécurité ou en une matière plastique transparente incassable. La plaque 8 est en métal ou en une matière plastique semi-rigide. Comme montré dans la figure 1, la plaque 8 comporte au moins un trou 12 pour le passage d'un commutateur rotatif de sélection de fonctions et/ou de calibres (seul le bouton de manœuvre 13 du commutateur rotatif a été représenté en trait mixte dans la figure 1) et elle comporte sur sa face supérieure des indications relatives aux fonctions et/ou aux calibres de l'appareil de mesure.

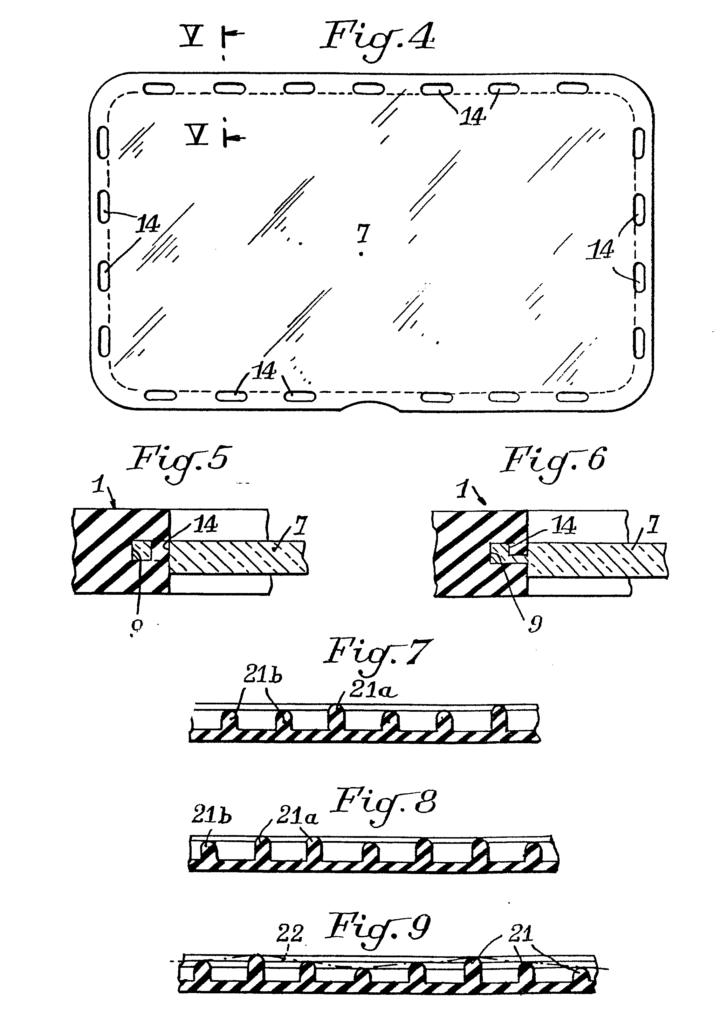

Afin d'éviter que les plaques 7 et 8 sortent de leurs feuillures respectives 9 et 11 en cas de choc sévère, chacune des deux plaques 7 et 8 comporte plusieurs cavités 14 comme cela est montré dans la figure 4 pour la plaque 7. Les cavités 14 ont par exemple une section de forme oblongue. Bien que les cavités 14 soient de préférence constituées par des trous traversants comme montré dans la figure 5, elles peuvent être aussi constituées par des trous borgnes profonds comme montré dans la figure 6. La partie supérieure 1 du boîtier est réalisée par surmoulage sur les plaques 7 et 8, de telle façon que la matière élastomère remplisse les cavités 14 des plaques 7 et 8 lors du moulage et assure ainsi une liaison pratiquement indétachable entre chacune des plaques 7 et 8 et la matière élastomère constituant la partie supérieure 1 du boîtier. Pour le moulage, on peut utiliser une technique de moulage par injection. La matière élastomère utilisée peut être un élastomère thermoplastique, comme par exemple un copolymère de styrène-butadiène-styrène (SBS) ayant une dureté shore comprise entre 60 et 70. De bons résultats ont été obtenus avec une matière élastomère vendue par la Société F. CHEVASSUS sous la référence commerciale « Fervanflex CT 1 060 ou 1 070 ».

Au moins deux parois latérales opposées 1b et 1c, de préférence les trois parois latérales 1b, 1c et 1d de la partie supérieure 1 du boîtier comportent, sur leur face intérieure, deux nervures 15 et 16, qui sont parallèles entre elles et à la paroi supérieure 1a et qui forment entre elles une feuillure élastique dans laquelle est encastrée une plaque 17 à circuits imprimés. Comme montré dans la figure 3, la nervure inférieure 16 a une section transversale en gros triangulaire, pour faciliter l'insertion par encliquetage élastique des bords de la plaque 17 dans la feuillure formée entre les deux nervures 15 et 16. La quatrième paroi latérale 1e de la partie supérieure 1 comporte plusieurs trous 18 (un seul trou est visible dans la figure 3) formant des traversées pour des douilles ou des bornes de raccordement 19 reliées électriquement aux circuits imprimés de la plaque 17, pour le branchement de l'appareil de mesure à des circuits extérieurs. Outre les circuits imprimés, la plaque 17 porte le commutateur rotatif susmentionné, les divers composants électriques et électroniques des circuits de mesure et l'indicateur de mesure (galvanomètre ou afficheur numérique), ce dernier étant placé au-dessous de la plaque transparente 7.

Chacune des parois 1a à 1e et 2a à 2e des parties supérieure et inférieure 1 et 2 du boîtier comporte, sur sa face extérieure, un réseau d'éléments 21 en relief, en matière élastomère, formant des amortisseurs de choc. Les éléments 21 en relief d'une même face extérieure ont des hauteurs différentes par rapport à la face extérieure considérée. Comme montré dans les figures 1 à 3, les éléments 21 en relief peuvent comprendre un premier groupe de nervures 21a et 21b parallèles entre elles et alternativement haute et basse, et un second groupe de nervures 21c et 21d, alternativement haute et basse, qui sont parallèles entre elles et qui intersectent à angles droits les nervures 21a et 21b du premier groupe. Ainsi, en cas de choc, par exemple lorsque l'appareil de mesure tombe au sol, le choc est tout d'abord amorti par les rainures 21a et 21c les plus saillantes, puis les nervures les moins saillantes 21b et 21d entrent aussi en action pour amortir le choc après que les nervures les plus saillantes ont été comprimées ou écrasées d'une quantité égale à la différence de hauteur des nervures. On obtient ainsi, de manière simple et facilement réalisable, une élasticité variable en fonction de l'épaisseur. Comme montré dans les figures 1 et 2, des nervures 21e, orientées à 45° par rapport aux nervures 21a à 21c, sont aussi prévues aux quatre angles du boîtier.

Bien que dans les figures 1 à 3, les nervures 21a et 21b ou 21c et 21d soient représentées alternativement haute et basse, on peut prévoir une autre distribution pour les nervures hautes et basses selon le degré d'élasticité désirée. Par exemple, on peut prévoir deux nervures basses 21b (et/ou 21d) pour une nervure haute 21a (et/ou 21c) comme montré dans la figure 7 ou, inversement, deux nervures hautes 21a (et/ou 21c) pour une nervure basse 21b (et/ou 21d) comme montré dans la figure 8. Afin d'obtenir une élasticité variant de manière encore plus progressive dans le sens de l'épaisseur, il est possible de prévoir des nervures 21 ayant des hauteurs telles que les sommets des nervures adjacentes se trouvent sur une ligne brisée ou sur une sinusoïde 22 comme montré dans la figure 9.

Il est du reste bien entendu que la forme d'exécution du boîtier qui a été décrite ci-dessus a été donnée à titre d'exemple purement indicatif et nullement limitatif, et que de nombreuses modifications peuvent être facilement apportées par l'homme de l'art sans pour autant sortir du cadre de la présente invention. C'est ainsi notamment que les cavités 14 prévues dans la périphérie de chacune des deux plaques 7 et 8, au lieu d'être constituées par des trous, peuvent être constituées par des encoches à section en T ou en queue-d'aronde, formées dans les bords des plaques 7 et 8. En outre, au lieu d'être réalisés sous la forme de nervures, les éléments 21 en relief peuvent être réalisés sous la forme de plots cylindriques ou tronconiques de différentes hauteurs. En outre, les parois latérales 1b à 1e de la partie supérieure 1 peuvent être moins hautes et les parois latérales 2b à 2e de la partie inférieure 2 plus hautes que celles montrées sur la figure 3. Dans ce cas, les nervures 15 et 16 peuvent être formées sur les faces intérieures des parois latérales 2a à 2d de la partie inférieure 2.

**Revendications**

1. Boîtier antichoc, notamment pour appareil portatif de mesure, comprenant deux parties (1 et 2) assemblables l'une à l'autre, en une matière élastomère moulable, l'une (1) des deux parties comportant une paroi principale (1a) ayant une ouverture (5) dans la périphérie de laquelle est formée une feuillure élastique d'encadrement (9), et une plaque (7) en une matière nettement plus rigide que ladite matière élastomère, qui est encastrée dans ladite feuillure, caractérisé en ce que ladite plaque (7) comporte plusieurs cavités (14) dans sa région périphérique encastrée dans la feuillure (9), et en ce que ladite partie (1) du boîtier qui comporte l'ouverture (5) est réalisée par surmoulage sur ladite plaque (7), de telle façon que la matière élastomère remplisse lesdites cavités (14) de la plaque (7) lors du moulage.

2. Boîtier antichoc selon la revendication 1, caractérisé en ce que lesdites cavités (14) sont des trous traversants.

3. Boîtier antichoc selon la revendication 1, caractérisé en ce que lesdites cavités (14) sont des trous borgnes.

4. Boîtier antichoc selon l'une quelconque des revendications 1 à 3, caractérisé en ce que ladite plaque (7) est en une matière transparente.

5. Boîtier antichoc selon l'une quelconque des revendications 1 à 4, caractérisé en ce que ladite paroi principale (1a) comporte une autre ouverture (6) dans la périphérie de laquelle est formée une autre feuillure élastique d'encadrement (11), une autre plaque rigide (8) étant encastrée dans ladite autre feuillure (11) et comportant, dans sa région périphérique, des cavités remplies de ladite matière élastomère.

6. Boîtier antichoc selon l'une quelconque des revendications 1 à 5, caractérisé en ce que au moins deux parois latérales opposées (1b et 1c) de l'une (1) des deux parties (1 et 2) du boîtier comportent, sur leur face intérieure, deux nervures (15 et 16) qui sont parallèles entre elles et à ladite paroi principale (1a) et qui forment entre elles une feuillure élastique dans laquelle est encastrée une plaque (17) à circuits imprimés.

7. Boîtier antichoc selon la revendication 6, caractérisé en ce que l'une (16) des deux nervures (15 et 16) a une section transversale en gros triangulaire.

8. Boîtier antichoc selon l'une quelconque des revendications 1 à 7, dans lequel chacune des parois (1a-1e et 2a-2e) du boîtier comporte sur sa face extérieure un réseau d'éléments (21) en relief, en une matière élastomère, formant des amortisseurs de choc, caractérisé en ce que les éléments (21) en relief d'une même face extérieure ont des hauteurs différentes par rapport à la face extérieure considérée.

9. Boîtier antichoc selon la revendication 8, caractérisé en ce que les éléments (21) en relief comprennent un premier groupe de nervures (21a et 21b) parallèles entre elles et un second groupe de nervures (21c et 21d) parallèles entre elles et intersectant à angles droits les nervures (21a et 21b) du premier groupe.

10. Boîtier antichoc selon la revendication 9, caractérisé en ce que les nervures de chacun des premier et second groupes sont alternativement

haute (21a et 21c) et basse (21b et 21d).

**Claims**

1. Shockproof box, particularly for a portable measuring device, having two parts (1, 2) which can be assembled with one another and made from a mouldable elastomeric material, one (1) of the two parts having a main wall (1a) with an opening (5), in the periphery of which is formed an elastic enclosing groove (9), and a plate (7) made from a much more rigid material than said elastomeric material and which is fixed in said groove, characterized in that said plate (7) has several cavities (14) in its peripheral region fixed in the said groove (9) and in that said part (1) of the box having the opening (5) is produced by overmoulding on said plate (7), in such a way that the elastomeric material fills the cavities (14) of plate (7) during moulding.

2. Shockproof box according to Claim 1, characterized in that the cavities (14) are through holes.

3. Shockproof box according to Claim 1, characterized in that the cavities (14) are blind holes.

4. Shockproof box according to one of the Claims 1 to 3, characterized in that plate (7) is made from a transparent material.

5. Shockproof box according to any one of the Claims 1 to 4, characterized in that the main wall (1a) has another opening (6), in whose periphery is formed another elastic enclosing groove (11), another rigid plate (8) being fixed in said other groove (11) and having, in its peripheral region, cavities filled with said elastomeric material.

6. Shockproof box according to any one of the claims 1 to 5, characterized in that at least two opposite side walls (1b, 1c) of one (1) of the two parts (1, 2) of the box have, on their inner face, two ribs (15, 16), which are parallel to one another and to said main wall (1a) and which form between them an elastic groove in which is fixed a printed circuit board (17).

7. Shockproof box according to Claim 6, characterized in that one (16) of the two ribs (15, 16) has a roughly triangular cross-section.

8. Shockproof box according to any one of the Claims 1 to 7, in which each of the walls (1a-1e) and (2a-2e) of the box has on its outer face a network of relief elements (21), made from an elastomeric material and forming shock absorbers, characterized in that the relief elements (21) on the same outer face have different heights with respect to the considered outer face.

9. Shockproof box according to Claim 8, characterized in that the relief elements (21) consist of a first group of ribs (21a, 21b), which are parallel to one another, and a second group of ribs (21c, 21d), which are parallel to one another and which intersect at right angles with the ribs (21a, 21b) of the first group.

10. Shockproof box according to Claim 9, characterized in that the ribs of each of the first and second groups are alternately high (21a, 21c) and low (21b, 21d).

**Patentansprüche**

1. Stoßsicheres Gehäuse, insbesondere für ein tragbares Meßgerät, umfassend zwei zusammenfügbare Teile (1 und 2), aus einem verformbaren elastomeren Material, wobei das eine (1) der zwei Teile eine Hauptwand (1a) enthält mit einer Öffnung (5) an deren Rand eine elastische Fuge zur Umrahmung (9) gebildet ist und eine Platte (7) aus einem viel steiferen Material als das beschriebene elastomere Material, die in dieser Fuge eingelassen ist, dadurch gekennzeichnet, daß diese Platte (7) mehrere Hohlräume (14) in ihrem Randgebiet enthält, das in die Fuge (9) eingelassen ist, und dadurch, daß dieser Teil (1) des Behälters, der die Öffnung (5) enthält, durch Abguß auf dieser Platte (7) hergestellt wird, auf eine solche Weise, daß das elastomere Material diese Hohlräume (14) der Platte (7) während des Gußes ausfüllt.

2. Stoßsicheres Gehäuse nach Anspruch 1, dadurch gekennzeichnet, daß diese Hohlräume (14) durchgehende Bohrungen sind.

3. Stoßsicheres Gehäuse nach Anspruch 1, dadurch gekennzeichnet, daß diese Hohlräume (14) Grundlöcher sind.

4. Stoßsicheres Gehäuse nach einem der Ansprüche 1 bis 3, dadurch gekennzeichnet, daß diese Platte (7) aus einem durchsichtigen Material besteht.

5. Stoßsicheres Gehäuse nach einem der Ansprüche 1 bis 4, dadurch gekennzeichnet, daß diese Hauptwand (1a) eine weitere Öffnung (6) enthält an deren Rand eine weitere elastische Fuge zur Umrahmung (11) gebildet ist, wobei eine weitere steife Platte (8) in dieser weiteren Fuge (11) eingelassen ist und in ihrem Randgebiet Hohlräume enthält, die mit diesem elastomeren Material gefüllt sind.

6. Stoßsicheres Gehäuse nach einem der Ansprüche 1 bis 5, dadurch gekennzeichnet, daß wenigstens zwei seitlich gegenüberliegende Wände (1b und 1c) des einen (1) der zwei Teile (1 und 2) des Behälters auf ihrer Innenseite zwei Rippen (15 und 16) enthalten, die parallel zueinander und zu dieser Hauptwand (1a) sind, und die untereinander eine elastische Fuge bilden, in welcher eine Platte (17) mit gedruckten Schaltungen eingelassen ist.

7. Stoßsicheres Gehäuse nach Anspruch 6, dadurch gekennzeichnet, daß eine (16) der zwei Rippen (15 und 16) einen im großen und ganzen dreickigen Querschnitt aufweist.

8. Stoßsicheres Gehäuse nach einem der Ansprüche 1 bis 7, in dem jede Wand (1a bis 1e und 2a bis 2e) des Behälters auf seiner Außenseite ein Netzwerk erhabener Elemente (21) enthält, aus einem elastomeren Material, welche Stoßdämpfer bilden, dadurch gekennzeichnet, daß die erhabenen Elemente (21) einer gleichen Außenseite unterschiedliche Höhen aufweisen in Bezug auf die betrachtete Außenseite.

9. Stoßsicheres Gehäuse nach Anspruch 8, dadurch gekennzeichnet, daß die erhabenen Elemente (21) eine erste Gruppe von untereinander parallelen Rippen (21a und 21b) und eine zweite Gruppe von untereinander parallelen Rippen (21c und 21d), welche die Rippen (21a und 21b) der ersten Gruppe im rechten Winkel schneiden, umfaßt.

10. Stoßsicheres Gehäuse nach Anspruch 9, dadurch gekennzeichnet, daß die Rippen jeder der ersten und zweiten Gruppen abwechselnd hoch (21a und 21c) und niedrig (21b und 21d) sind.

Fig. 1

Fig. 2

EP 0 176 644 B1

# Fig.3

EP 0 176 644 B1

*Fig.4*

*Fig.5*

*Fig.6*

*Fig.7*

*Fig.8*

*Fig.9*